# FASCICULE DE BREVET EUROPEEN

(11) **EP 4 025 723 B1**
(45) Date de publication et mention de la délivrance du brevet: **26.06.2024**
(21) Numéro de dépôt: 20775694.1
(22) Date de dépôt: 28.08.2020
(51) Int. Cl.: C23C 28/04, C23C 4/02, C23C 4/10, C23C 4/129, C23C 4/134, C23C 4/18, C23C 10/02, C23C 10/10, C23C 10/12, C23C 10/28, C23C 10/32, C23C 10/52, C23C 10/54, C23C 10/58, C23C 10/60, C23C 14/02, C23C 14/06, C23C 14/58, C23C 24/08, C23C 28/00

(54) **PIÈCE REVÊTUE COMPRENANT UN REVÊTEMENT PROTECTEUR À BASE DE PHASES MAX**
BESCHICHTETES TEIL MIT EINER AUF MAX-PHASEN BASIERENDEN SCHUTZSCHICHT
COATED PART COMPRISING A PROTECTIVE COATING BASED ON MAX PHASES

(30) Priorité: 06.09.2019 FR 1909805
(43) Date de publication de la demande: 13.07.2022
(73) Titulaire: Safran, 75015 Paris (FR)
(72) Inventeur: JOULIA, Aurélien, 77550 MOISSY-CRAMAYEL (FR); SALLOT, Pierre, Jean, 77550 MOISSY-CRAMAYEL (FR)
(74) Mandataire: Cabinet Beau de Loménie
(86) Numéro de dépôt international: PCT/FR2020/051510
(87) Numéro de publication internationale: WO 2021/044093

(56) Documents cités:
- WO-A1-2014/193549
- WO-A1-2015/080839
- WO-A1-2018/166748
- WO-A1-2018/184782
- WO-A1-2019/081870

## Description

### Domaine Technique

La présente invention concerne une pièce comprenant un substrat métallique revêtu d'une barrière thermique recouverte par un revêtement protecteur comprenant au moins deux phases MAX de compositions distinctes. La présente invention vise également le procédé de fabrication d'une telle pièce, et son utilisation à haute température et sous une atmosphère oxydante.

### Technique antérieure

Afin d'améliorer leur rendement, les turbines haute pression (TuHP) des systèmes stationnaires terrestres ou pour propulsion aéronautique sont soumises à des températures de plus en plus élevées. Dans ces conditions, les composants métalliques des TuHP nécessitent d'être davantage protégés pour maintenir leur température de surface à un niveau suffisamment bas pour garantir leur intégrité fonctionnelle et limiter leur oxydation et corrosion par l'atmosphère environnante. Pour répondre à cela, il est connu d'utiliser des barrières thermiques qui sont généralement constituées d'une couche, dite couche d'accrochage, permettant une protection contre l'oxydation et la corrosion, et qui est déposée à la surface du composant, ainsi que d'une couche céramique surmontant cette couche d'accrochage dont la fonction première est de limiter la température de surface des composants revêtus.

Afin d'assurer sa fonction de protection contre l'oxydation et la corrosion et de favoriser l'accrochage du revêtement céramique, la couche d'accrochage est préoxydée afin de former à sa surface une couche d'alumine dense. Cette couche d'alumine est communément désignée par l'expression « Thermally Growth Oxide » ou « TGO » dans la littérature anglo-saxonne.

La durée de vie des barrières thermiques est conditionnée par la résistance de l'empilement au cyclage thermique, d'une part, et par sa résistance aux agressions environnementales d'autre part (érosion par les particules solides, résistance chimique, corrosion ...). En particulier, les systèmes connus peuvent se dégrader lorsqu'ils sont exposés à une ambiance riche en particules de sable (riche en composés inorganiques de type silice), ou encore à des éléments communément appelés CMAS (pour oxydes de « Calcium-Magnésium AluminoSilicate »).

En effet, l'infiltration des CMAS à l'état fondu dans la barrière thermique peut généralement produire une dégradation par rigidification de la couche infiltrée conduisant à une rupture mécanique, et par déstabilisation par dissolution chimique de la barrière thermique.

Pour s'affranchir de cette problématique, des compositions dites anti-CMAS, principalement à base de cations de terres rares tels les zirconates de terres rares, comme Gd₂Zr₂O₇ ou Nd₂Zr₂O₇, ont été développées en mettant à profit la formation d'une couche barrière étanche par réaction chimique avec le CMAS. Toutefois ces systèmes peuvent présenter des limitations réduisant leur efficacité et menant à des durées de vie opérationnelles qui peuvent être améliorées. En effet, la réaction des CMAS avec les matériaux dits anti-CMAS nécessite la dissolution dudit matériau dans le CMAS pour qu'il précipite en des phases stables à la température de fonctionnement permettant de bloquer l'infiltration. Or, ces réactions nécessitent la pénétration du CMAS sur une certaine profondeur du revêtement anti-CMAS, ce qui fragilise le système barrière thermique d'un point de vue mécanique. En effet, la ténacité intrinsèque des zirconates de terres rares (K_{1C_Gd2Zr2O7} = 0,5-1,0 MPa.m^{0,5}) est très inférieure à celle de la zircone yttriée partiellement stabilisée typiquement utilisée dans la barrière thermique (K_{1C_8YPSZ} = 3-4 MPa.m^{0,5}). Ceci peut rendre les couches céramiques à base de zirconates de terre rare sensibles à l'écaillage progressif lorsque cette couche est imprégnée de CMAS et soumise à des cycles thermiques ou au phénomène d'érosion.

Ainsi, il est souhaitable de disposer de nouvelles solutions pour améliorer la durée de vie des revêtements de barrière thermique.

### Exposé de l'invention

La présente invention est divulguée aux revendications 1 à 12.

La présente invention vise selon un premier mode de réalisation une pièce revêtue comprenant :
- un substrat métallique,
- une barrière thermique comprenant un matériau céramique et recouvrant le substrat métallique,
caractérisée en ce que la pièce revêtue comprend en outre un revêtement protecteur recouvrant la barrière thermique, le revêtement protecteur comprenant, dans une première zone, une première phase MAX, notée PZ2, de formule (ZrₓTi₁₋ₓ)₂AlC ou une première phase MAX, notée PC2, de formule (CrₓTi₁₋ₓ)₂AlC avec x non nul et inférieur ou égal à 1 dans les phases MAX PZ2 et PC2, et le revêtement protecteur comprenant, dans une deuxième zone recouvrant la première zone, une deuxième phase MAX de formule Ti₂AlC.

La présente invention vise selon un deuxième mode de réalisation une pièce revêtue comprenant :
- un substrat métallique,
- une barrière thermique comprenant un matériau céramique et recouvrant le substrat métallique,
caractérisée en ce que la pièce revêtue comprend en outre un revêtement protecteur recouvrant la barrière thermique, le revêtement protecteur comprenant, dans une première zone, une première phase MAX, notée PZ3, de formule (ZrₓTi₁₋ₓ)₃AlC₂ ou une première phase MAX, notée PC3, de formule (CrₓTi₁₋ₓ)₃AlC₂ avec x non nul et inférieur ou égal à 1 dans les phases MAX PZ3 et PC3, et le revêtement protecteur comprenant, dans une deuxième zone recouvrant la première zone, une deuxième phase MAX de formule Ti₃AlC₂.

Le revêtement protecteur à base de phases MAX décrit plus haut forme une couche d'alumine (Al₂O₃) à sa surface lorsqu'il est soumis à une haute température en milieu oxydant. Cette couche d'alumine permet d'améliorer la résistance à l'oxydation et à la corrosion mais aussi de fournir une protection contre les CMAS. En effet, la couche d'alumine générée réagit avec le CMAS liquide pour former une couche réactive dense constituée d'un mélange majoritaire de phases d'anorthite (CaAl₂Si₂O₈) et de spinelle (MgAl₂O₄), ce qui permet d'éviter l'infiltration de la barrière thermique sous-jacente. En outre, la première zone comprenant une phase MAX à base de zirconium ou de chrome intercalée entre la deuxième zone et la barrière thermique permet de limiter la diffusion croisée entre les éléments de la barrière thermique et de la deuxième phase MAX. Cela améliore la compatibilité chimique entre les différents éléments du revêtement de la pièce. La première zone permet aussi d'accommoder les déformations mécaniques induites par la différence de coefficients de dilatation thermique entre la deuxième phase MAX et la barrière thermique, ce qui participe aussi à améliorer la durée de vie du revêtement de la pièce à chaud.

Ainsi, le revêtement protecteur mis en oeuvre dans le cadre de l'invention permet d'améliorer la protection de la barrière thermique contre les CMAS et l'oxydation. En particulier, le revêtement protecteur fournit une meilleure protection qu'une simple couche de Ti₂AlC ou de Ti₃AlC₂ (comme il est divulgué dans WO 2019/081870 A1, WO 2015/080839 A1 et WO 2018/184782 A1) déposée directement sur la barrière thermique du fait de la présence de la première zone qui améliore la compatibilité chimique de l'ensemble et accommode les déformations en fonctionnement. Le revêtement protecteur présente en outre une ténacité élevée lui conférant une bonne résistance au cyclage thermique, une bonne tenue à l'érosion et à l'écaillage progressif généré par les CMAS imprégnés au sein du revêtement protecteur en fonctionnement.

Dans un exemple de réalisation, l'épaisseur de la première zone est supérieure ou égale à 0,5 fois l'épaisseur de la deuxième zone, de préférence supérieure ou égale à l'épaisseur de la deuxième zone.

Une telle caractéristique permet d'améliorer davantage encore la compatibilité chimique et d'accommoder davantage encore les déformations mécaniques en fonctionnement.

En particulier, le rapport [épaisseur de la première zone] / [épaisseur de la deuxième zone] peut être compris entre 1 et 5, de préférence entre 1 et 3.

Dans un exemple de réalisation, le revêtement protecteur comprend en outre une zone intercalaire située entre la première zone et la barrière thermique, la zone intercalaire comprenant du zirconium ou un alliage de zirconium, ou du chrome ou un alliage de chrome.

Le fait de déposer du zirconium ou du chrome avant le reste du revêtement protecteur permet d'éviter tout risque de dégradation de la barrière thermique sous-jacente par érosion durant la formation du revêtement protecteur lorsqu'une technique de projection de particules est utilisée. La présence de la zone intercalaire dans la pièce revêtue après formation du revêtement protecteur permet en outre d'améliorer davantage encore la compatibilité chimique entre la barrière thermique et le reste du revêtement protecteur.

Dans le cas particulier du deuxième mode de réalisation, le revêtement protecteur peut, en outre, comprendre une couche protectrice supplémentaire recouvrant la deuxième zone et comprenant une phase MAX de formule Ti₂AlC.

L'ajout de cette couche protectrice Ti₂AlC permet d'améliorer davantage encore la stabilité de la couche protectrice d'alumine formée par rapport à l'emploi seul de Ti₃AlC₂. Cela permet d'améliorer les performances de la pièce lorsqu'elle est employée à une température particulièrement élevée.

Dans un exemple de réalisation, le substrat métallique est une pièce de turbomachine. En particulier, le substrat métallique peut être une pièce de turbine. Le substrat métallique peut être une aube de turbomachine, par exemple une aube de turbine, ou un distributeur.

L'invention vise également une turbomachine comprenant une pièce revêtue telle que décrite plus haut. La turbomachine peut être une turbomachine d'un moteur aéronautique ou être une turbomachine industrielle. Ainsi, l'invention vise en particulier un aéronef comprenant une telle turbomachine ou encore une installation industrielle comprenant une telle turbomachine.

L'invention vise également un procédé de fabrication d'une pièce revêtue selon la revendication 8.

Dans ce cas relatif au premier mode de réalisation, la première zone résulte de la diffusion du zirconium ou du chrome dans la phase Ti₂AlC pour former une solution solide. Dans ce cas, x est inférieur à 1, c'est-à-dire que les phases MAX PZ2 et PC2 comprennent à la fois du zirconium et du titane ou du chrome et du titane. La diffusion du zirconium ou du chrome est réalisée sous l'effet d'un traitement thermique. On notera que cette diffusion peut être réalisée lors du dépôt de la deuxième phase MAX, si celle-ci est déposée à haute température, comme c'est le cas lors de l'emploi d'une technique de projection thermique par exemple. On ne sort toutefois pas du cadre de l'invention lorsque ce traitement thermique de diffusion constitue une étape distincte réalisée après le dépôt de la deuxième phase MAX, par exemple dans le cas où la deuxième phase MAX est déposée à basse température par exemple par projection à froid ou par électrophorèse.

L'invention vise également un procédé de fabrication d'une pièce selon la revendication 9.

Dans ce cas relatif au premier mode de réalisation, on dépose directement les matériaux correspondant aux phases souhaitées dans les première et deuxième zones. En d'autres termes, les premières et deuxièmes zones sont formées sans nécessiter de diffusion de zirconium ou de chrome dans la phase MAX Ti₂AlC à la différence du cas qui vient d'être décrit. On forme ainsi deux couches distinctes correspondant à chacune des première et deuxième zones.

L'invention vise également un procédé de fabrication d'une pièce selon la revendication 10.

Dans ce cas relatif au deuxième mode de réalisation, la première zone résulte de la diffusion du zirconium ou du chrome dans la phase Ti₃AlC₂ pour former une solution solide. Dans ce cas, x est inférieur à 1, c'est-à-dire que les phases MAX PZ3 et PC3 comprennent à la fois du zirconium et du titane ou du chrome et du titane. Cette diffusion peut être réalisée lors du dépôt de la deuxième phase MAX ou après ce dépôt comme indiqué plus haut.

L'invention vise également un procédé de fabrication d'une pièce selon la revendication 11.

Dans ce cas relatif au deuxième mode de réalisation, on dépose directement les matériaux correspondant aux phases souhaitées dans les première et deuxième zones. En d'autres termes, les premières et deuxièmes zones sont formées sans nécessiter de diffusion de zirconium ou de chrome dans la phase MAX Ti₃AlC₂ à la différence du cas qui vient d'être décrit. On forme ainsi deux couches distinctes correspondant à chacune des première et deuxième zones.

L'invention vise également un procédé d'utilisation d'une pièce telle que décrite plus haut, le procédé comprenant une étape d'utilisation de ladite pièce à une température supérieure ou égale à 800°C en milieu oxydant.

### Brève description des dessins

[Fig. 1] La figure 1 illustre de manière schématique un premier exemple de pièce revêtue selon l'invention.
[Fig. 2] La figure 2 illustre de manière schématique un deuxième exemple de pièce revêtue selon l'invention.
[Fig. 3] La figure 3 illustre de manière schématique un troisième exemple de pièce revêtue selon l'invention.
[Fig. 4] La figure 4 illustre de manière schématique un quatrième exemple de pièce revêtue selon l'invention.
[Fig. 5] La figure 5 est une vue en perspective d'un substrat métallique pouvant être mis en oeuvre dans le cadre de l'invention lequel constitue une aube de turbomachine.
[Fig. 6] La figure 6 est une vue en perspective d'une roue de turbomachine incorporant une pluralité de pièces revêtues selon l'invention.
[Fig. 7] La figure 7 illustre une première étape d'un procédé de fabrication de la pièce selon le premier exemple illustré à la figure 1.
[Fig. 8] La figure 8 illustre une deuxième étape d'un procédé de fabrication de la pièce selon le premier exemple illustré à la figure 1.
[Fig. 9] La figure 9 illustre l'obtention de la pièce selon le premier exemple illustré à la figure 1 après diffusion entre les éléments déposés.
[Fig. 10] La figure 10 illustre une première étape d'un procédé de fabrication de la pièce selon le troisième exemple illustré à la figure 3.
[Fig. 11] La figure 11 illustre une deuxième étape d'un procédé de fabrication de la pièce selon le troisième exemple illustré à la figure 3.
[Fig. 12] La figure 12 illustre une troisième étape d'un procédé de fabrication de la pièce selon le troisième exemple illustré à la figure 3.
[Fig. 13] La figure 13 illustre une quatrième étape d'un procédé de fabrication de la pièce selon le troisième exemple illustré à la figure 3.

### Description des modes de réalisation

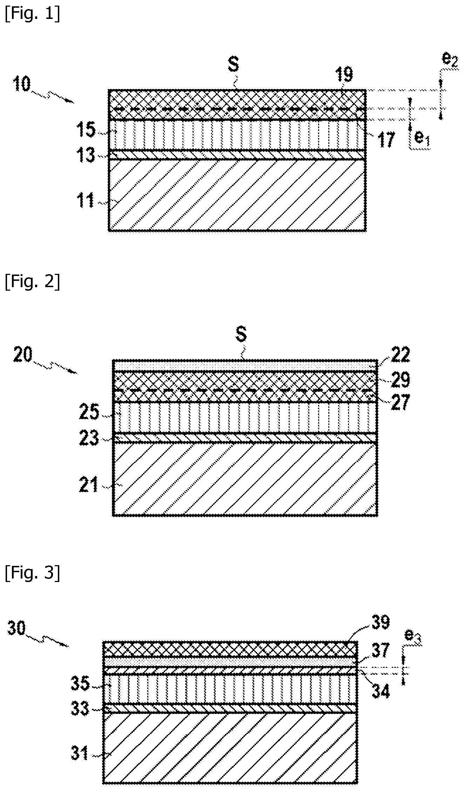

On va décrire la structure de plusieurs exemples de pièces revêtues 10, 20, 30 ou 40 selon l'invention en lien avec les figures 1 à 4. Ces pièces 10-40 comprennent chacune un substrat métallique 11, 21, 31 ou 41 revêtu par une couche d'accrochage 13, 23, 33 ou 43 elle-même recouverte par une couche céramique 15, 25, 35 ou 45 de barrière thermique.

Le substrat métallique 11-41 peut être un superalliage, par exemple un superalliage base nickel ou cobalt. La couche d'accrochage 13-43 peut comporter un alliage MCrAlY avec M désignant le nickel, le cobalt ou une association nickel-cobalt, ou un aluminure de nickel. La couche d'accrochage 13-43 peut être au contact du substrat métallique 11-41. La couche d'accrochage 13-43 fait partie d'une barrière thermique qui comprend, en outre, la couche céramique 15-45 recouvrant la couche d'accrochage 13-43. La couche d'accrochage 13-43 est présente entre la couche céramique 15-45 et le substrat métallique 11-41. La couche céramique 15-45 peut être au contact de la couche d'accrochage 13-43. La couche céramique 15-45 peut comprendre de la zircone, de la zircone yttriée stabilisée par l'oxyde d'yttrium ou partiellement stabilisée par l'oxyde d'yttrium (« Yttria Stabilized Zirconia » dite « YSZ » ou « Yttria Partially Stabilized Zirconia » dite « YPSZ ») ou un zirconate de terre rare, comme du zirconate de gadolinium Gd₂Zr₂O₇. La couche céramique 15-45 peut avoir une structure colonnaire. L'ensemble constitué par le substrat 11-41, la couche d'accrochage 13-43 et la couche céramique 15-45 est connu en soi.

Les figures 1 à 4 représentent le cas d'une barrière thermique constituée de seulement deux couches, avec une couche d'accrochage 13-43 et une couche céramique 15-45 mais on ne sort pas du cadre de l'invention lorsque la barrière thermique comprend plus de deux couches, et par exemple plus de deux couches céramiques.

Les différents exemples de pièces revêtues 10-40 qui sont illustrés aux figures 1 à 4 diffèrent en termes de revêtement protecteur mis en oeuvre.

Quel que soit l'exemple considéré, le revêtement protecteur recouvre la barrière thermique. Le revêtement protecteur peut être en contact avec la barrière thermique. Le revêtement protecteur peut définir la couche externe du revêtement de la pièce 10-40, c'est-à-dire la couche la plus éloignée du substrat métallique 11-41.

Le revêtement protecteur comprend une composition évolutive évoluant (i) soit entre une phase MAX PZ2 ou PC2 dans la première zone 17, 27, 37 ou 47 et Ti₂AlC dans la deuxième zone 19, 29, 39 ou 49, ou (ii) soit entre une phase MAX PZ3 ou PC3 dans la première zone 17-47 et Ti₃AlC₂ dans la deuxième zone 19-49. La première zone 17-47 est superposée à la barrière thermique. La barrière thermique est entre le substrat métallique 11-41 et la première zone 17-47. La première zone 17-47 peut être en contact avec la barrière thermique. Dans les formules des phases MAX PZ2, PC2, PZ3 et PC3, x est non nul, égal à 1 ou inférieur à 1. La première zone 17-47 peut être en contact avec la couche céramique 15-45 de la barrière thermique. La deuxième zone 19-49 est superposée à la première zone 17-47. La première zone 17-47 est située entre la barrière thermique et la deuxième zone 19-49. La première zone 17-47 est située entre la couche céramique 15-45 de la barrière thermique et la deuxième zone 19-49. La deuxième zone 19-49 peut être en contact avec la première zone 17-47. La deuxième zone 19-49 est plus éloignée du substrat métallique 11-41 que la première zone 17-47.

Quel que soit l'exemple considéré, l'épaisseur du revêtement protecteur peut être supérieure ou égale à 5 µm, par exemple être comprise entre 5 µm et 500 µm, préférentiellement entre 5 µm et 50 µm. L'épaisseur e₁ de la première zone 17-47 peut être supérieure ou égale à 0,1 µm, par exemple être comprise entre 0,1 µm et 50 µm. L'épaisseur e₂ de la deuxième zone 19-49 peut être supérieure ou égale à 1 µm, par exemple être comprise entre 1 µm et 50 µm. Le revêtement protecteur peut être poreux ou non-poreux. Dans le cas où le revêtement protecteur est poreux, il peut être avantageux de limiter sa porosité à une valeur inférieure ou égale à 20% en volume.

On vient de décrire des caractéristiques du revêtement protecteur qui sont applicables quel que soit l'exemple de pièce considéré. On va maintenant décrire les caractéristiques spécifiques à chacun des exemples illustrés aux figures 1 à 4.

Dans le cas de la pièce 10 illustrée à la figure 1, la deuxième zone 19 définit la surface externe S de la pièce 10. Dans cet exemple, la première zone 17 comprend une phase MAX PZ2, PC2, PZ3 ou PC3 avec x inférieur à 1. Ainsi, la phase MAX de la première zone 17 comprend à la fois du titane et du chrome, ou du titane et du zirconium. Dans le cas de la figure 1, cette phase MAX résulte d'une diffusion entre éléments déposés ce qui aboutit à un revêtement protecteur constitué par une seule et même couche comprenant la première zone et la deuxième zone.

L'exemple de pièce 20 illustré à la figure 2 ne diffère de la pièce 10 qu'en ce que le revêtement protecteur comprend en outre une couche protectrice supplémentaire 22 recouvrant la deuxième zone 29 et comprenant une phase MAX de formule Ti₂AlC et en ce que la deuxième zone 29 comprend une phase MAX Ti₃AlC₂ et la première zone 27 une phase MAX PZ3 ou PC3. La couche protectrice supplémentaire 22 définit ici la surface externe S de la pièce 20. La couche protectrice supplémentaire 22 peut être au contact de la deuxième zone 29.

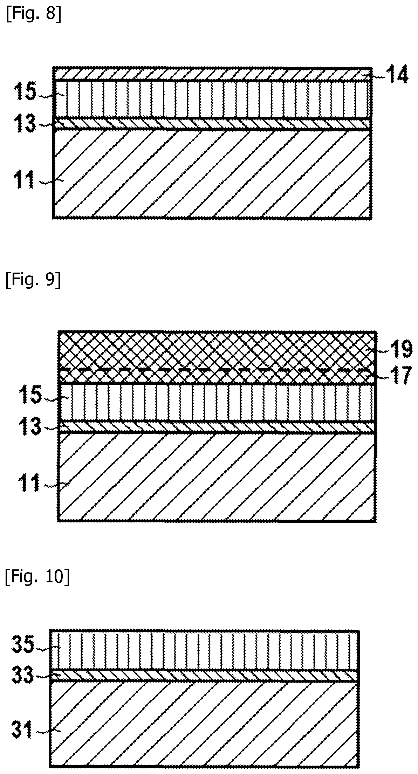

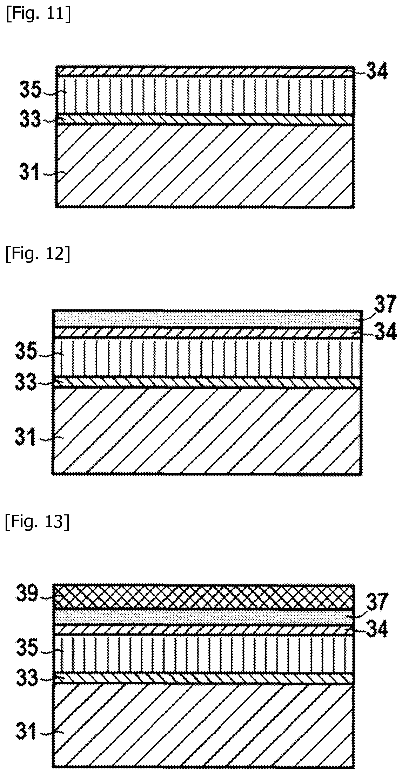

L'exemple de pièce 30 illustré à la figure 3 comprend les première 37 et deuxième 39 zones sous la forme de couches distinctes. Comme cela sera repris plus bas en lien avec les figures 10 à 13, la formation de la première zone ne résulte pas ici d'une diffusion du zirconium ou du chrome dans une phase MAX Ti₂AlC ou Ti₃AlC₂ mais les matériaux correspondant aux phases souhaitées dans les première 37 et deuxième 39 zones ont directement été déposés. L'exemple de la figure 3 comprend en outre une couche intercalaire 34 de zirconium ou d'un alliage de zirconium, ou de chrome ou d'un alliage de chrome présente sur la barrière thermique. La couche intercalaire 34 est située entre la couche céramique 35 de la barrière thermique et la première zone 37. Cette couche intercalaire 34 est d'abord déposée afin d'éviter tout risque de dégradation de la barrière thermique lors du dépôt des couches formant les première 37 et deuxième 39 zones. L'épaisseur e₃ de la couche intercalaire 34 peut être inférieure ou égale à 20 µm, par exemple être comprise entre 2 µm et 10 µm.

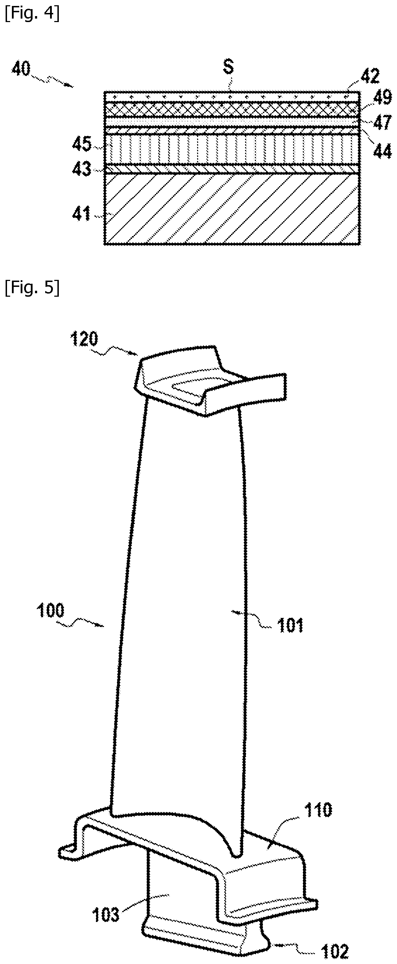

L'exemple de pièce 40 illustré à la figure 4 ne diffère de la pièce 30 selon le troisième exemple qu'en ce que le revêtement protecteur comprend en outre une couche protectrice supplémentaire 42 recouvrant la deuxième zone 49 et comprenant une phase MAX de formule Ti₂AlC et en ce que la deuxième zone 49 comprend une phase MAX Ti₃AlC₂ et la première zone 47 une phase MAX PZ3 ou PC3. La couche protectrice supplémentaire 42 définit ici la surface externe S de la pièce 40. La couche protectrice supplémentaire 42 peut être au contact de la deuxième zone 49. La pièce 40 comprend aussi une couche intercalaire 44 ayant les mêmes propriétés que la couche 34 décrite plus haut.

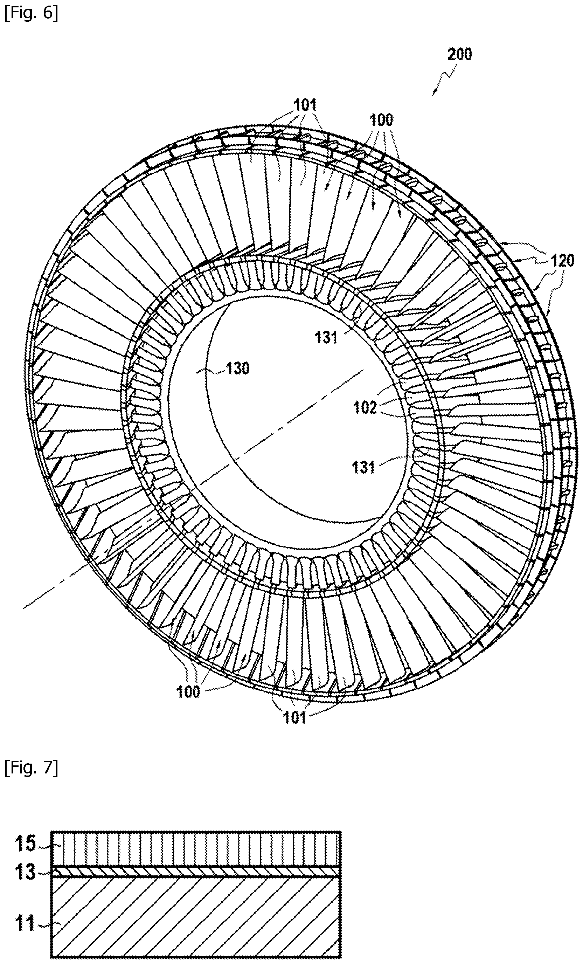

On va maintenant décrire une application possible pour la pièce revêtue selon l'invention dans le cadre de l'intégration à une turbomachine en lien avec les figures 5 et 6.

La figure 5 illustre une aube de turbomachine 100 revêtue constituant un exemple possible de pièce revêtue selon l'invention. Dans l'exemple de la figure 5, le substrat métallique définit une aube de turbomachine qui comprend une pale 101, un pied 102 formé par une partie de plus forte épaisseur, par exemple à section en forme de bulbe, prolongé par une échasse 103, une plateforme intérieure 110 située entre l'échasse 103 et la pale 101 et une plateforme extérieure ou talon 120 au voisinage de l'extrémité libre de la pale.

La figure 6 illustre l'intégration de l'aube 100 de turbomachine dans une roue 200 de turbomachine. La figure 6 illustre une roue 200 de turbomachine comprenant un moyeu 130 sur lequel sont montées une pluralité d'aubes 100, chaque aube 100 comportant un pied 102 formé par une partie de plus forte épaisseur, par exemple à section en forme de bulbe, qui est engagée dans un logement correspondant 131 ménagé à la périphérie du moyeu 130 et une pale 101. La roue 200 comporte, en outre, plusieurs éléments de talon d'aube 120 montés sur chacune des aubes 100.

Les figures 1 à 6 qui viennent d'être décrites visent des exemples de structures possibles pour les pièces revêtues selon l'invention. La description des figures 7 à 13 qui va suivre s'attache à décrire l'aspect relatif à la fabrication de telles pièces revêtues.

Les figures 7 à 9 concernent la fabrication de l'exemple de pièce 10 de la figure 1. Le matériau de départ comprend le substrat métallique 11, la couche d'accrochage 13 et la couche céramique 15 (figure 7). Le revêtement protecteur est ensuite formé en déposant tout d'abord une couche 14 de zirconium ou d'un alliage de zirconium, ou une couche 14 de chrome ou d'un alliage de chrome sur la couche céramique 15 (figure 8). La couche 14 peut être déposée au contact de la couche céramique 15. Une deuxième phase MAX de formule Ti₂AlC ou Ti₃AlC₂ est ensuite déposée sur la couche 14. Diverses techniques sont utilisables pour déposer la couche 14 et la deuxième phase MAX. On utilise une technique de projection, par exemple de projection thermique, ou la voie sol-gel ou l'électrophorèse ou une technique de dépôt en phase vapeur par exemple de dépôt physique en phase vapeur (PVD - « Physical Vapor Déposition »). A titre d'exemples de techniques utilisables, on peut citer : la pulvérisation à froid (« cold spray »), la projection plasma à pression atmosphérique (APS - « Atmospheric Plasma Spraying »), la projection plasma de suspensions (SPS - « Suspension Plasma Spraying), la projection plasma de solutions (SPPS - « Solution Precursor Plasma Spraying »), la projection par flamme à grande vitesse en voie poudre (HVOF - High Velocity Oxygen Fuel »), la projection par flamme à grande vitesse en voie poudre sous air (HVAF - « High Velocity Air Fuel »), la projection par flamme à grande vitesse en voie liquide (HVSFS - « High Velocity Suspension Flame Spray »), l'évaporation sous faisceaux d'électrons (EB-PVD - « Electron-Beam Physical Vapor Déposition »), la pulvérisation cathodique magnétron pulse à haute puissance (HiPIMS - « High Power Impulse Magnetron Sputtering »).

Comme indiqué plus haut, lorsque la deuxième phase MAX est déposée à haute température comme c'est le cas par exemple dans un procédé de projection thermique, le zirconium ou le chrome de la couche 14 diffuse dans la deuxième phase MAX durant l'étape de dépôt de cette dernière. La diffusion du zirconium ou du chrome dans la deuxième phase MAX est réalisée en imposant une température supérieure ou égale à 900°C, par exemple comprise entre 900°C et 1200°C.

La couche 14 présente la même nature que la couche intercalaire 34 ou 44 évoquée plus haut et permet donc d'éviter tout risque de dégradation de la barrière thermique sous-jacente lors de l'étape de dépôt du revêtement protecteur (évite tout risque d'érosion de la barrière thermique par les particules projetées). En plus de cela, dans le cas particulier de la figure 1, la couche 14 est aussi utilisée dans le cas de la pièce 10 de la figure 1 pour obtenir la première zone 17 ayant une phase MAX mixte à base de zirconium et titane, ou chrome et titane par diffusion des éléments déposés.

A l'issue de la diffusion du zirconium ou du chrome dans la deuxième phase MAX, on obtient la pièce 10 présentant un revêtement protecteur ayant la première zone 17 et la deuxième zone 19 (figure 9). Le procédé peut être poursuivi en déposant une couche protectrice supplémentaire 22 si cela est souhaité afin d'obtenir la pièce 20 selon la figure 2.

Les figures 10 à 13 concernent le cas de la pièce 30 de la figure 3 pour lequel il n'y a pas nécessité d'employer un phénomène de diffusion des éléments déposés afin de former la première zone 37. On part d'un matériau de départ comprenant substrat métallique 31, couche d'accrochage 33 et couche céramique 35. La couche intercalaire 34 à base de zirconium ou chrome est ensuite déposée sur la couche céramique 35. Comme indiqué plus haut, cette couche intercalaire 34 permet en particulier d'éviter tout risque de dégradation de la barrière thermique sous-jacente lors de l'étape de dépôt du revêtement protecteur. Ensuite, les matériaux souhaités pour constituer les première et deuxième zones sont directement déposés sur cette couche intercalaire 34. Les techniques évoquées plus haut sont utilisées pour déposer chacune des couches 34, 37 et 39. Selon cet exemple, la couche intercalaire 34 à base de zirconium ou de chrome se retrouve dans la pièce revêtue finie obtenue après formation du revêtement protecteur. Bien entendu, on peut si cela est souhaité former une couche protectrice supplémentaire 42.

Une fois la pièce revêtue, on peut réaliser avant la première utilisation un traitement thermique de pré-oxydation préalable à une température comprise entre 950°C et 1100°C afin de former la couche d'alumine protectrice. En variante, cette couche d'alumine peut se former *in situ* en cours du fonctionnement à chaud en milieu oxydant.

## Revendications

1. Pièce revêtue (10-40) comprenant :
- un substrat métallique (11-41),
- une barrière thermique comprenant un matériau céramique (15-45) et recouvrant le substrat métallique,
**caractérisée en ce que** la pièce revêtue comprend en outre un revêtement protecteur recouvrant la barrière thermique, le revêtement protecteur comprenant, dans une première zone (17-47), une première phase MAX, notée PZ2, de formule (ZrₓTi₁₋ₓ)₂AlC ou une première phase MAX, notée PC2, de formule (CrₓTi₁₋ₓ)₂AlC avec x non nul et inférieur ou égal à 1 dans les phases MAX PZ2 et PC2, et le revêtement protecteur comprenant, dans une deuxième zone (19-49) recouvrant la première zone, une deuxième phase MAX de formule Ti₂AlC.

2. Pièce revêtue (10-40) comprenant :
- un substrat métallique (11-41),
- une barrière thermique comprenant un matériau céramique (15-45) et recouvrant le substrat métallique,
**caractérisée en ce que** la pièce revêtue comprend en outre un revêtement protecteur recouvrant la barrière thermique, le revêtement protecteur comprenant, dans une première zone (17-47), une première phase MAX, notée PZ3, de formule (ZrₓTi₁₋ₓ)₃AlC₂ ou une première phase MAX, notée PC3, de formule (CrₓTi₁₋ₓ)₃AlC₂ avec x non nul et inférieur ou égal à 1 dans les phases MAX PZ3 et PC3, et le revêtement protecteur comprenant, dans une deuxième zone (19-49) recouvrant la première zone, une deuxième phase MAX de formule Ti₃AlC₂.

3. Pièce revêtue (10-40) selon la revendication 1 ou 2, dans laquelle l'épaisseur (e₁) de la première zone (17-47) est supérieure ou égale à 0,5 fois l'épaisseur (e₂) de la deuxième zone (19-49).

4. Pièce revêtue (30-40) selon l'une quelconque des revendications 1 à 3, dans laquelle le revêtement protecteur comprend en outre une zone intercalaire (34 ; 44) située entre la première zone (37 ; 47) et la barrière thermique, la zone intercalaire comprenant du zirconium ou un alliage de zirconium, ou du chrome ou un alliage de chrome.

5. Pièce revêtue (20 ; 40) selon la revendication 2 ou selon la revendication 3 ou 4 rattachée à la revendication 2, dans laquelle le revêtement protecteur comprend, en outre, une couche protectrice supplémentaire (22 ; 42) recouvrant la deuxième zone (29 ; 49) et comprenant une phase MAX de formule Ti₂AlC.

6. Pièce revêtue (10-40) selon l'une quelconque des revendications 1 à 5, dans laquelle le substrat métallique est une pièce de turbomachine.

7. Turbomachine comprenant une pièce revêtue (10-40) selon la revendication 6.

8. Procédé de fabrication d'une pièce revêtue (10 ; 20) selon la revendication 1 ou selon l'une quelconque des revendications 3, 4 ou 6 rattachées à la revendication 1 et avec x inférieur à 1 dans les phases MAX PZ2 et PC2,
le procédé comprenant lorsque la première zone (17 ; 27) comprend la première phase MAX PZ2 :
- le dépôt de zirconium ou d'un alliage de zirconium sur la barrière thermique, ce dépôt étant réalisé par une technique de projection, de dépôt en phase vapeur, par voie sol-gel ou par électrophorèse,
- le dépôt de la deuxième phase MAX de formule Ti₂AlC sur le zirconium ou l'alliage de zirconium précédemment déposé, ce dépôt étant réalisé par une technique de projection, de dépôt en phase vapeur, par voie sol-gel ou par électrophorèse, et
- un traitement thermique de diffusion du zirconium dans la deuxième phase MAX de formule Ti₂AlC en imposant une température supérieure ou égale à 900°C afin d'obtenir la pièce revêtue,
ou le procédé comprenant lorsque la première zone comprend la première phase MAX PC2 :
- le dépôt de chrome ou d'un alliage de chrome sur la barrière thermique, ce dépôt étant réalisé par une technique de projection, de dépôt en phase vapeur, par voie sol-gel ou par électrophorèse,
- le dépôt de la deuxième phase MAX de formule Ti₂AlC sur le chrome ou l'alliage de chrome précédemment déposé, ce dépôt étant réalisé par une technique de projection, de dépôt en phase vapeur, par voie sol-gel ou par électrophorèse, et
- un traitement thermique de diffusion du chrome dans la deuxième phase MAX de formule Ti₂AlC en imposant une température supérieure ou égale à 900°C afin d'obtenir la pièce revêtue.

9. Procédé de fabrication d'une pièce (30 ; 40) selon la revendication 1 ou selon l'une quelconque des revendications 3, 4 ou 6 rattachées à la revendication 1 et avec x inférieur ou égal à 1 dans les phases MAX PZ2 et PC2,
le procédé comprenant lorsque la première zone (37 ; 47) comprend la première phase MAX PZ2 :
- le dépôt d'une première couche de la première phase MAX PZ2 formant la première zone, ce dépôt étant réalisé par une technique de projection, de dépôt en phase vapeur, par voie sol-gel ou par électrophorèse, et
- le dépôt d'une deuxième couche de la deuxième phase MAX de formule Ti₂AlC sur la première couche, la deuxième couche formant la deuxième zone (39 ; 49), ce dépôt étant réalisé par une technique de projection, de dépôt en phase vapeur, par voie sol-gel ou par électrophorèse,
ou le procédé comprenant lorsque la première zone comprend la première phase MAX PC2 :
- le dépôt d'une première couche de la première phase MAX PC2 formant la première zone, ce dépôt étant réalisé par une technique de projection, de dépôt en phase vapeur, par voie sol-gel ou par électrophorèse, et
- le dépôt d'une deuxième couche de la deuxième phase MAX de formule Ti₂AlC sur la première couche, la deuxième couche formant la deuxième zone, ce dépôt étant réalisé par une technique de projection, de dépôt en phase vapeur, par voie sol-gel ou par électrophorèse.

10. Procédé de fabrication d'une pièce (10 ; 20) selon la revendication 2 ou selon l'une quelconque des revendications 3 à 6 rattachées à la revendication 2 et avec x inférieur à 1 dans les phases MAX PZ3 et PC3,
le procédé comprenant lorsque la première zone (17 ; 27) comprend la première phase MAX PZ3 :
- le dépôt de zirconium ou d'un alliage de zirconium sur la barrière thermique, ce dépôt étant réalisé par une technique de projection, de dépôt en phase vapeur, par voie sol-gel ou par électrophorèse,
- le dépôt de la deuxième phase MAX de formule Ti₃AlC₂ sur le zirconium ou l'alliage de zirconium précédemment déposé, ce dépôt étant réalisé par une technique de projection, de dépôt en phase vapeur, par voie sol-gel ou par électrophorèse, et
- un traitement thermique de diffusion du zirconium dans la deuxième phase MAX de formule Ti₃AlC₂ en imposant une température supérieure ou égale à 900°C afin d'obtenir la pièce revêtue,
ou le procédé comprenant lorsque la première zone comprend la première phase MAX PC3 :
- le dépôt de chrome ou d'un alliage de chrome sur la barrière thermique, ce dépôt étant réalisé par une technique de projection, de dépôt en phase vapeur, par voie sol-gel ou par électrophorèse,
- le dépôt de la deuxième phase MAX de formule Ti₃AlC₂ sur le chrome ou l'alliage de chrome précédemment déposé, ce dépôt étant réalisé par une technique de projection, de dépôt en phase vapeur, par voie sol-gel ou par électrophorèse, et
- un traitement thermique de diffusion du chrome dans la deuxième phase MAX de formule Ti₃AlC₂ en imposant une température supérieure ou égale à 900°C afin d'obtenir la pièce revêtue.

11. Procédé de fabrication d'une pièce (30 ; 40) selon la revendication 2 ou selon l'une quelconque des revendications 3 à 6 rattachées à la revendication 2 et avec x inférieur ou égal à 1 dans les phases MAX PZ3 et PC3,
le procédé comprenant lorsque la première zone (37 ; 47) comprend la première phase MAX PZ3 :
- le dépôt d'une première couche de la première phase MAX PZ3 formant la première zone, ce dépôt étant réalisé par une technique de projection, de dépôt en phase vapeur, par voie sol-gel ou par électrophorèse, et
- le dépôt d'une deuxième couche de la deuxième phase MAX de formule Ti₃AlC₂ sur la première couche, la deuxième couche formant la deuxième zone (39 ; 49), ce dépôt étant réalisé par une technique de projection, de dépôt en phase vapeur, par voie sol-gel ou par électrophorèse,
ou le procédé comprenant lorsque la première zone comprend la première phase MAX PC3 :
- le dépôt d'une première couche de la première phase MAX PC3 formant la première zone, ce dépôt étant réalisé par une technique de projection, de dépôt en phase vapeur, par voie sol-gel ou par électrophorèse, et
- le dépôt d'une deuxième couche de la deuxième phase MAX de formule Ti₃AlC₂ sur la première couche, la deuxième couche formant la deuxième zone, ce dépôt étant réalisé par une technique de projection, de dépôt en phase vapeur, par voie sol-gel ou par électrophorèse.

12. Procédé d'utilisation d'une pièce (10-40) selon l'une quelconque des revendications 1 à 6, le procédé comprenant une étape d'utilisation de ladite pièce à une température supérieure ou égale à 800°C en milieu oxydant.

## Patentansprüche

1. Beschichtetes Teil (10-40), umfassend:
- ein Metallsubstrat (11-41),
- eine thermische Barriere, die ein Keramikmaterial (15-45) umfasst und das Metallsubstrat bedeckt,
**dadurch gekennzeichnet, dass** das beschichtete Teil ferner eine Schutzbeschichtung umfasst, welche die thermische Barriere bedeckt, und die Schutzbeschichtung in einer ersten Zone (17-47) eine erste Phase MAX, die als PZ2 bezeichnet wird und die Formel (ZrₓTi₁₋ₓ)₂AlC aufweist, oder eine erste Phase MAX umfasst, die als PC2 bezeichnet wird und die Formel (CrₓTi₁₋ₓ)₂AlC aufweist, wobei in den Phasen MAX PZ2 und PC2 x ungleich null und kleiner oder gleich 1 ist, und die Schutzbeschichtung in einer zweiten Zone (19-49), welche die erste Zone bedeckt, eine zweite Phase MAX mit der Formel Ti₂AlC umfasst.

2. Beschichtetes Teil (10-40), umfassend:
- ein Metallsubstrat (11-41),
- eine thermische Barriere, die ein Keramikmaterial (15-45) umfasst und das Metallsubstrat bedeckt,
**dadurch gekennzeichnet, dass** das beschichtete Teil ferner eine Schutzbeschichtung umfasst, welche die thermische Barriere bedeckt, und die Schutzbeschichtung in einer ersten Zone (17-47) eine erste Phase MAX, die als PZ3 bezeichnet wird und die Formel (ZrₓTi₁₋ₓ)₂AlC₂ aufweist, oder eine erste Phase MAX umfasst, die als PC3 bezeichnet wird und die Formel (CrₓTi₁₋ₓ)₃AlC₂ aufweist, wobei in den Phasen MAX PZ3 und PC3 x ungleich null und kleiner oder gleich 1 ist, und die Schutzbeschichtung in einer zweiten Zone (19-49), welche die erste Zone bedeckt, eine zweite Phase MAX mit der Formel Ti₃AlC₂ umfasst.

3. Beschichtetes Teil (10-40) nach Anspruch 1 oder 2, wobei die Dicke (e₁) der ersten Zone (17-47) größer oder gleich dem 0,5-Fachen der Dicke (e₂) der zweiten Zone (19-49) ist.

4. Beschichtetes Teil (30-40) nach einem der Ansprüche 1 bis 3, wobei die Schutzbeschichtung ferner eine Zwischenzone (34; 44) umfasst, die sich zwischen der ersten Zone (37; 47) und der thermischen Barriere befindet, wobei die Zwischenzone Zirkonium oder eine Zirkoniumlegierung, oder Chrom oder eine Chromlegierung umfasst.

5. Beschichtetes Teil (20; 40) nach Anspruch 2 oder nach Anspruch 3 oder 4, sofern abhängig von Anspruch 2, wobei die Schutzbeschichtung ferner eine zusätzliche Schutzschicht (22; 42) umfasst, welche die zweite Zone (29; 49) bedeckt und eine Phase MAX mit der Formel Ti₂AlC umfasst.

6. Beschichtetes Teil (10-40) nach einem der Ansprüche 1 bis 5, wobei das Metallsubstrat ein Teil einer Turbomaschine ist.

7. Turbomaschine, umfassend ein beschichtetes Teil (10-40) nach Anspruch 6.

8. Verfahren zur Herstellung eines beschichteten Teils (10; 20) nach Anspruch 1 oder nach einem der Ansprüche 3, 4 oder 6, sofern abhängig von Anspruch 1 und x in den Phasen MAX PZ2 und PC2 kleiner als 1 ist, wobei das Verfahren umfasst, wenn die erste Zone (17; 27) die erste Phase MAX PZ2 umfasst:
- die Abscheidung von Zirkonium oder einer Zirkoniumlegierung auf der thermischen Barriere, wobei diese Ablagerung durch eine Spritz-, Dampfabscheidungstechnik, durch einen Sol-Gel-Prozess oder durch Elektrophorese verwirklicht wird,
- die Abscheidung der zweiten Phase MAX mit der Formel Ti₂AlC auf dem Zirkonium oder der Zirkoniumlegierung, das/die zuvor abgeschieden wurde, wobei diese Ablagerung durch eine Spritz-, Dampfabscheidungstechnik, durch einen Sol-Gel-Prozess oder durch Elektrophorese verwirklicht wird, und
- eine Wärmebehandlung zur Diffusion des Zirkoniums in der zweiten Phase MAX mit der Formel Ti₂AlC, durch Festlegen einer Temperatur von mehr als oder gleich 900 °C, um das beschichtete Teil zu erhalten,
oder wobei das Verfahren umfasst, wenn die erste Zone die erste Phase MAX PC2 umfasst:
- die Abscheidung von Chrom oder einer Chromlegierung auf der thermischen Barriere, wobei diese Ablagerung durch eine Spritz-, Dampfabscheidungstechnik, durch einen Sol-Gel-Prozess oder durch Elektrophorese verwirklicht wird,
- die Abscheidung der zweiten Phase MAX mit der Formel Ti₂AlC auf dem Chrom oder der Chromlegierung, das/die zuvor abgeschieden wurde, wobei diese Ablagerung durch eine Spritz-, Dampfabscheidungstechnik, durch einen Sol-Gel-Prozess oder durch Elektrophorese verwirklicht wird, und
- eine Wärmebehandlung zur Diffusion des Chroms in der zweiten Phase MAX mit der Formel Ti₂AlC, durch Festlegen einer Temperatur von mehr als oder gleich 900 °C, um das beschichtete Teil zu erhalten.

9. Verfahren zur Herstellung eines beschichteten Teils (30; 40) nach Anspruch 1 oder nach einem der Ansprüche 3, 4 oder 6, sofern abhängig von Anspruch 1 und x in den Phasen MAX PZ2 und PC2 kleiner als oder gleich 1 ist, wobei das Verfahren umfasst, wenn die erste Zone (37; 47) die erste Phase MAX PZ2 umfasst:
- die Abscheidung einer ersten Schicht der ersten Phase MAX PZ2, welche die erste Zone bildet, wobei diese Ablagerung durch eine Spritz-, Dampfabscheidungstechnik, durch einen Sol-Gel-Prozess oder durch Elektrophorese verwirklicht wird, und
- die Abscheidung einer zweiten Schicht der zweiten Phase MAX mit der Formel Ti₂AlC auf der ersten Schicht, wobei die zweite Schicht die zweite Zone (39; 49) bildet, wobei diese Ablagerung durch eine Spritz-, Dampfabscheidungstechnik, durch einen Sol-Gel-Prozess oder durch Elektrophorese verwirklicht wird,
oder wobei das Verfahren umfasst, wenn die erste Zone die erste Phase MAX PC2 umfasst:
- die Abscheidung einer ersten Schicht der ersten Phase MAX PC2, welche die erste Zone bildet, wobei diese Ablagerung durch eine Spritz-, Dampfabscheidungstechnik, durch einen Sol-Gel-Prozess oder durch Elektrophorese verwirklicht wird, und
- die Abscheidung einer zweiten Schicht der zweiten Phase MAX mit der Formel Ti₂AlC auf der ersten Schicht, wobei die zweite Schicht die zweite Zone bildet, wobei diese Ablagerung durch eine Spritz-, Dampfabscheidungstechnik, durch einen Sol-Gel-Prozess oder durch Elektrophorese verwirklicht wird.

10. Verfahren zur Herstellung eines beschichteten Teils (10; 20) nach Anspruch 2 oder nach einem der Ansprüche 3 bis 6, sofern abhängig von Anspruch 2 und x in den Phasen MAX PZ3 und PC3 kleiner als 1 ist, wobei das Verfahren umfasst, wenn die erste Zone (17; 27) die erste Phase MAX PZ3 umfasst:
- die Abscheidung von Zirkonium oder einer Zirkoniumlegierung auf der thermischen Barriere, wobei diese Ablagerung durch eine Spritz-, Dampfabscheidungstechnik, durch einen Sol-Gel-Prozess oder durch Elektrophorese verwirklicht wird,
- die Abscheidung der zweiten Phase MAX mit der Formel Ti₃AlC₂ auf dem Zirkonium oder der Zirkoniumlegierung, das/die zuvor abgeschieden wurde, wobei diese Ablagerung durch eine Spritz-, Dampfabscheidungstechnik, durch einen Sol-Gel-Prozess oder durch Elektrophorese verwirklicht wird, und
- eine Wärmebehandlung zur Diffusion des Zirkoniums in der zweiten Phase MAX mit der Formel Ti₃AlC₂, durch Festlegen einer Temperatur von mehr als oder gleich 900 °C, um das beschichtete Teil zu erhalten,
oder wobei das Verfahren umfasst, wenn die erste Zone die erste Phase MAX PC3 umfasst:
- die Abscheidung von Chrom oder einer Chromlegierung auf der thermischen Barriere, wobei diese Ablagerung durch eine Spritz-, Dampfabscheidungstechnik, durch einen Sol-Gel-Prozess oder durch Elektrophorese verwirklicht wird,
- die Abscheidung der zweiten Phase MAX mit der Formel Ti₃AlC₂ auf dem Chrom oder der Chromlegierung, das/die zuvor abgeschieden wurde, wobei diese Ablagerung durch eine Spritz-, Dampfabscheidungstechnik, durch einen Sol-Gel-Prozess oder durch Elektrophorese verwirklicht wird, und
- eine Wärmebehandlung zur Diffusion des Chroms in der zweiten Phase MAX mit der Formel Ti₃AlC₂, durch Festlegen einer Temperatur von mehr als oder gleich 900 °C, um das beschichtete Teil zu erhalten.

11. Verfahren zur Herstellung eines beschichteten Teils (30; 40) nach Anspruch 2 oder nach einem der Ansprüche 3 bis 6, sofern abhängig von Anspruch 2 und x in den Phasen MAX PZ3 und PC3 kleiner als oder gleich 1 ist, wobei das Verfahren umfasst, wenn die erste Zone (37; 47) die erste Phase MAX PZ3 umfasst:
- die Abscheidung einer ersten Schicht der ersten Phase MAX PZ3, welche die erste Zone bildet, wobei diese Ablagerung durch eine Spritz-, Dampfabscheidungstechnik, durch einen Sol-Gel-Prozess oder durch Elektrophorese verwirklicht wird, und
- die Abscheidung einer zweiten Schicht der zweiten Phase MAX mit der Formel Ti₃AlC₂ auf der ersten Schicht, wobei die zweite Schicht die zweite Zone (39; 49) bildet, wobei diese Ablagerung durch eine Spritz-, Dampfabscheidungstechnik, durch einen Sol-Gel-Prozess oder durch Elektrophorese verwirklicht wird,
oder wobei das Verfahren umfasst, wenn die erste Zone die erste Phase MAX PC3 umfasst:
- die Abscheidung einer ersten Schicht der ersten Phase MAX PC3, welche die erste Zone bildet, wobei diese Ablagerung durch eine Spritz-, Dampfabscheidungstechnik, durch einen Sol-Gel-Prozess oder durch Elektrophorese verwirklicht wird, und
- die Abscheidung einer zweiten Schicht der zweiten Phase MAX mit der Formel Ti₃AlC₂ auf der ersten Schicht, wobei die zweite Schicht die zweite Zone bildet, wobei diese Ablagerung durch eine Spritz-, Dampfabscheidungstechnik, durch einen Sol-Gel-Prozess oder durch Elektrophorese verwirklicht wird.

12. Verfahren zur Verwendung eines Teils (10-40) nach einem der Ansprüche 1 bis 6, wobei das Verfahren einen Schritt der Verwendung des Teils bei einer Temperatur von mehr als oder gleich 800 °C in einem oxidierenden Milieu umfasst.

## Claims

1. Coated part (10-40) comprising:
- a metallic substrate (11-41),
- a thermal barrier comprising a ceramic material (15-45) and covering the metallic substrate,
**characterised in that** the coated part further comprises a protective coating covering the thermal barrier, the protective coating comprising, in a first region (17-47), a first MAX phase, denoted PZ2, of formula (ZrₓTi₁₋ₓ)₂AlC or a first MAX phase, denoted PC2, of formula (CrₓTi₁₋ₓ)₂AlC with x non-zero and less than or equal to 1 in the MAX phases PZ2 and PC2, and the protective coating comprising, in a second region (19-49) covering the first region, a second MAX phase of formula Ti₂AlC.

2. Coated part (10-40) comprising:
- a metallic substrate (11-41),
- a thermal barrier comprising a ceramic material (15-45) and covering the metallic substrate,
**characterised in that** the coated part further comprises a protective coating covering the thermal barrier, the protective coating comprising, in a first region (17-47), a first MAX phase, denoted PZ3, of formula (ZrₓTi₁₋ₓ)₃AlC₂ or a first MAX phase, denoted PC3, of formula (CrₓTi₁₋ₓ)₃AlC₂ with x non-zero and less than or equal to 1 in the MAX phases PZ3 and PC3, and the protective coating comprising, in a second region (19-49) covering the first region, a second MAX phase of formula Ti₃AlC₂.

3. Coated part (10-40) according to claim 1 or 2, wherein the thickness (e₁) of the first region (17-47) is greater than or equal to 0.5 times the thickness (e₂) of the second region (19-49).

4. Coated part (30-40) according to any one of claims 1 to 3, wherein the protective coating further comprises an intermediate region (34; 44) located between the first region (37; 47) and the thermal barrier, the intermediate region comprising zirconium or an alloy of zirconium, or chromium or an alloy of chromium.

5. Coated part (20; 40) according to claim 2, or according to claim 3 or 4 referring to claim 2, wherein the protective coating further comprises an additional protective layer (22; 42) covering the second region (29; 49) and comprising a MAX phase of formula Ti₂AlC.

6. Coated part (10-40) according to any one of claims 1 to 5, wherein the metallic substrate is a turbomachine part.

7. Turbomachine comprising a coated part (10-40) according to claim 6.

8. Method for manufacturing a coated part (10; 20) according to claim 1, or according to any one of claims 3, 4 or 6 referring to claim 1, and with x less than 1 in the MAX phases PZ2 and PC2,
the method comprising, when the first region (17; 27) comprises the first MAX phase PZ2:
- depositing zirconium or a zirconium alloy on the thermal barrier, this deposition being performed by a spray technique, vapour phase deposition, sol-gel route or electrophoresis,
- depositing the second MAX phase of formula Ti₂AlC on the previously deposited zirconium or zirconium alloy, this deposition being performed by a spray technique, vapour phase deposition, sol-gel route or electrophoresis, and
- a heat treatment for zirconium diffusion into the second MAX phase of formula Ti₂AlC by imposing a temperature greater than or equal to 900°C in order to obtain the coated part,
or the method comprising, when the first region comprises the first MAX phase PC2:
- depositing chromium or a chromium alloy on the thermal barrier, this deposition being performed by a spray technique, vapour phase deposition, sol-gel route or electrophoresis,
- depositing the second MAX phase of formula Ti₂AlC on the previously deposited chromium or chromium alloy, this deposition being performed by a spray technique, vapour phase deposition, sol-gel route or electrophoresis, and
- a heat treatment for chromium diffusion into the second MAX phase of formula Ti₂AlC by imposing a temperature greater than or equal to 900°C in order to obtain the coated part.

9. Method for manufacturing a part (30; 40) according to claim 1, or according to any one of claims 3, 4 or 6 referring to claim 1, and with x less than or equal to 1 in the MAX phases PZ2 and PC2,
the method comprising, when the first region (37; 47) comprises the first MAX phase PZ2:
- depositing a first layer of the first MAX phase PZ2 forming the first region, this deposition being performed by a spray technique, vapour phase deposition, sol-gel route or electrophoresis, and
- depositing a second layer of the second MAX phase of formula Ti₂AlC on the first layer, the second layer forming the second region (39; 49), this deposition being performed by a spray technique, vapour phase deposition, sol-gel route or electrophoresis,
or the method comprising, when the first region comprises the first MAX phase PC2:
- depositing a first layer of the first MAX phase PC2 forming the first region, this deposition being performed by a spray technique, vapour phase deposition, sol-gel route or electrophoresis, and
- depositing a second layer of the second MAX phase of formula Ti₂AlC on the first layer, the second layer forming the second region, this deposition being performed by a spray technique, vapour phase deposition, sol-gel route or electrophoresis.

10. Method for manufacturing a coated part (10; 20) according to claim 2, or according to any one of claims 3 to 6 referring to claim 2, and with x less than 1 in the MAX phases PZ3 and PC3,
the method comprising, when the first region (17; 27) comprises the first MAX phase PZ3:
- depositing zirconium or a zirconium alloy on the thermal barrier, this deposition being performed by a spray technique, vapour phase deposition, sol-gel route or electrophoresis,
- depositing the second MAX phase of formula Ti₃AlC₂ on the previously deposited zirconium or zirconium alloy, this deposition being performed by a spray technique, vapour phase deposition, sol-gel route or electrophoresis, and
- a heat treatment for zirconium diffusion into the second MAX phase of formula Ti₃AlC₂ by imposing a temperature greater than or equal to 900°C in order to obtain the coated part,
or the method comprising, when the first region comprises the first MAX phase PC3:
- depositing chromium or a chromium alloy on the thermal barrier, this deposition being performed by a spray technique, vapour phase deposition, sol-gel route or electrophoresis,
- depositing the second MAX phase of formula Ti₃AlC₂ on the previously deposited chromium or chromium alloy, this deposition being performed by a spray technique, vapour phase deposition, sol-gel route or electrophoresis, and
- a heat treatment for chromium diffusion into the second MAX phase of formula Ti₃AlC₂ by imposing a temperature greater than or equal to 900°C in order to obtain the coated part.

11. Method for manufacturing a coated part (30; 40) according to claim 2, or according to any one of claims 3 to 6 referring to claim 2, and with x less than or equal to 1 in the MAX phases PZ3 and PC3,
the method comprising, when the first region (37; 47) comprises the first MAX phase PZ3:
- depositing a first layer of the first MAX phase PZ3 forming the first region, this deposition being performed by a spray technique, vapour phase deposition, sol-gel route or electrophoresis, and
- depositing a second layer of the second MAX phase of formula Ti₃AlC₂ on the first layer, the second layer forming the second region (39; 49), this deposition being performed by a spray technique, vapour phase deposition, sol-gel route or electrophoresis,
or the method comprising, when the first region comprises the first MAX phase PC3:
- depositing a first layer of the first MAX phase PC3 forming the first region, this deposition being performed by a spray technique, vapour phase deposition, sol-gel route or electrophoresis, and
- depositing a second layer of the second MAX phase of formula Ti₃AlC₂ on the first layer, the second layer forming the second region, this deposition being performed by a spray technique, vapour phase deposition, sol-gel route or electrophoresis.

12. Method for using a part (10-40) according to any one of claims 1 to 6, the method comprising a step of using said part at a temperature greater than or equal to 800°C in an oxidizing environment.
